# FASCICULE DE BREVET EUROPEEN

(11) **EP 0 733 990 B1**
(45) Date de publication et mention de la délivrance du brevet: **04.09.2002**
(21) Numéro de dépôt: 96400537.5
(22) Date de dépôt: 15.03.1996
(51) Int. Cl.: G06K 11/16, G06F 3/033

(54) **Dispositif de désignation tactile à surface capacitive transparente à haute résolution**
Berührungsempfindliches Bestimmungsgerät mit einer durchsichtigen kapazitiven Oberfläche und hoher Auflösung
High resolution tactile designation device with a capacitive transparent surface

(30) Priorité: 24.03.1995 FR 9503501
(43) Date de publication de la demande: 25.09.1996
(73) Titulaire: THALES AVIONICS S.A., 78141 Vélizy Villacoublay Cédex (FR)
(72) Inventeur: Coni, Philippe, 92402 Courbevoie Cedex (FR); Fagard, Pierre, 92402 Courbevoie Cedex (FR)
(74) Mandataire: Chaverneff, Vladimir

(56) Documents cités:
- EP-A- 0 372 964
- EP-A- 0 561 669
- EP-A- 0 567 364
- GB-A- 2 205 164
- PATENT ABSTRACTS OF JAPAN vol. 9, no. 62 (P-342), 19 Mars 1985 & JP-A-59 197933 (FUJITSU KK), 9 Novembre 1984,

## Description

La présente invention se rapporte à un dispositif de désignation tactile à surface capacitive transparente à haute résolution.

On utilise des surfaces tactiles transparentes devant des afficheurs d'images, ces images pouvant être très diverses, afin de leur adjoindre une fonction de désignation tactile, fonction qui est ainsi réalisée de façon simple mécaniquement et électriquement, sans atténuer notablement la vue de ces images, et ce, pour un coût peu élevé. Dans le cas de l'application à des afficheurs de petite taille (surface inférieure à 100 x 100 mm), les contraintes d'encombrement et de coût sont déterminantes.

Lorsque ces surfaces tactiles sont continues, c'est-à-dire lorsqu'elles ne comportent pas de zones de désignation matérialisées par un réseau matriciel de conducteurs, mais une surface conductrice continue associée à une détection capacitive, leur résolution de sélection peut être très élevée.

Les surfaces tactiles transparentes connues comportent généralement les éléments suivants :
- une plaque de verre partiellement recouverte d'un dépôt métallique très mince et transparent, gravé dans le cas du mode de réalisation capacitif discret, et non gravé s'il s'agit du mode capacitif continu,
- un détecteur d'effort sur lequel la plaque de verre repose, ce détecteur étant constitué de capteurs réalisés à l'aide de lames métalliques dont on mesure la déformation à l'aide de jauges de contrainte résistives, et disposés aux quatre coins de la plaque de verre,
- un circuit de raccordement pour alimenter les plages de détection de la plaque,
- un circuit de raccordement des détecteurs d'effort,
- un dispositif mécanique de support maintenant en position l'ensemble des éléments et permettant d'effectuer les ajustements mécaniques éventuellement nécessaires,
- un circuit électronique d'alimentation en énergie et de traitement des signaux issus des plages de détection, et
- un circuit électronique de traitement des signaux des capteurs d'effort.

Les surfaces tactiles connues, comprenant les éléments cités ci-dessus, présentent plusieurs inconvénients. Tout d'abord, lorsque l'on grave sur la plaque de verre des touches discrètes, chaque touche comporte sa propre piste conductrice d'alimentation, et on constate qu'il est très difficile de réaliser un revêtement anti-reflets efficace sur la plaque à cause des très faibles résistances de connexion de touche requises pour obtenir une bonne sensibilité, ce qui nécessite une forte épaisseur de la couche métallique. De plus, ce mode de réalisation nécessite un grand nombre de connexions (une par touche), et donc un nombre corrélativement élevé de circuits électroniques reliés à ces touches. Cette solution est techniquement exploitable, car elle offre une bonne sensibilité (l'utilisateur peut porter des gants), mais est onéreuse à cause du procédé de réalisation de la plaque de verre gravée et du grand nombre de connexions nécessaires.

D'autres problèmes sont dus au montage mécanique de la plaque de verre. Celle-ci étant montée flottante sur ses capteurs d'effort, on rencontre des difficultés dans son guidage mécanique, dans la réalisation d'un ensemble de connexions capables de suivre les mouvements de la plaque, et dans la nécessité de la réalisation d'un dispositif d'ajustement en hauteur de chaque capteur d'effort, de façon à pouvoir compenser les tolérances de positionnement.

Enfin, du fait que la plaque de verre est équipée d'un circuit souple de raccordement (entre les touches et les circuits électroniques qui doivent leur être reliés), les opérations de mise en place et de démontage de cette plaque sont délicates.

On connaît d'après la demande de brevet britannique GB-A-2 205 164 un dispositif de désignation tactile à surface capacitive transparente carrée comportant un premier groupe d'électrodes formées en ses quatre coins, et un second groupe d'électrodes formées au milieu de ses côtés. La détermination d'un point d'attouchement de cette surface consiste à alimenter simultanément toutes les électrodes d'un groupe et à mesurer les différents courants passant par les électrodes, puis à alimenter simultanément toutes les électrodes de l'autre groupe en effectuant des mesures similaires, afin d'augmenter la précision de détermination. En outre, ce document précise qu'il est nécessaire que la surface capacitive soit de résistivité uniforme, ce qui implique une couche métallisée relativement épaisse, donc de qualités optiques dégradées. Le principe même de mesure nécessite une surface d'attouchement quasi ponctuelle, afin de ne pas trop perturber la régularité du champ électrique au niveau de la surface transparente. De plus, le circuit de mesure relié à cette surface capacitive nécessite des circuits d'interface ("drivers") à impédances appairées, et la mesure peut être perturbée par une dérive des caractéristiques des composants de ce circuit. Cette dérive est difficile et complexe à compenser.

La présente invention a pour objet un dispositif de désignation tactile à surface tactile transparente à haute résolution dont la précision dépende le moins possible de la façon dont se fait l'attouchement (pointe, doigt à plat, doigt ganté, ...) et ne dépende pas de la dérive des composants et de l'homogénéité de la surface capacitive, qui nécessite peu de connexions, qui soit peu onéreux, dont la fixation mécanique soit simple à réaliser et à mettre en place, tout en présentant une bonne sensibilité.

Le dispositif de désignation tactile conforme à l'invention comporte une plaque de verre sensiblement rectangulaire à dépôt métallique transparent continu, cette plaque étant supportée en ses coins par des lames flexibles sur lesquelles sont fixées des jauges de contrainte, ces lames pouvant assurer la connexion électrique entre le dépôt métallique de la plaque de verre et des circuits électroniques, cette connexion comportant un condensateur série, les circuits électroniques comportant des circuits d'alimentation haute fréquence et un calculateur, et ce dispositif est caractérisé par le fait qu'il comporte un circuit de détection dont un pôle est alternativement relié à chacun des coins du dépôt métallique, le coin opposé étant relié à l'autre pôle du circuit de détection, les deux autres coins étant non connectés.

La présente invention sera mieux comprise à la lecture de la description détaillée d'un mode de réalisation, pris à titre d'exemple non limitatif et illustré par le dessin annexé, sur lequel :
- la figure 1 est un bloc-diagramme d'un système de désignation tactile comprenant le dispositif de l'invention,
- les figures 2 à 5 sont des vues de détails de réalisation de composants du dispositif de l'invention,
- la figure 6 est un bloc-diagramme des circuits de liaison entre surface tactile et circuits de détection, dans le dispositif conforme à l'invention,
- la figure 7 est un diagramme montrant un exemple de processus de commutation des circuits de liaison de la figure 6, et
- la figure 8 est un chronogramme de signaux apparaissant dans le circuit de la figure 6.

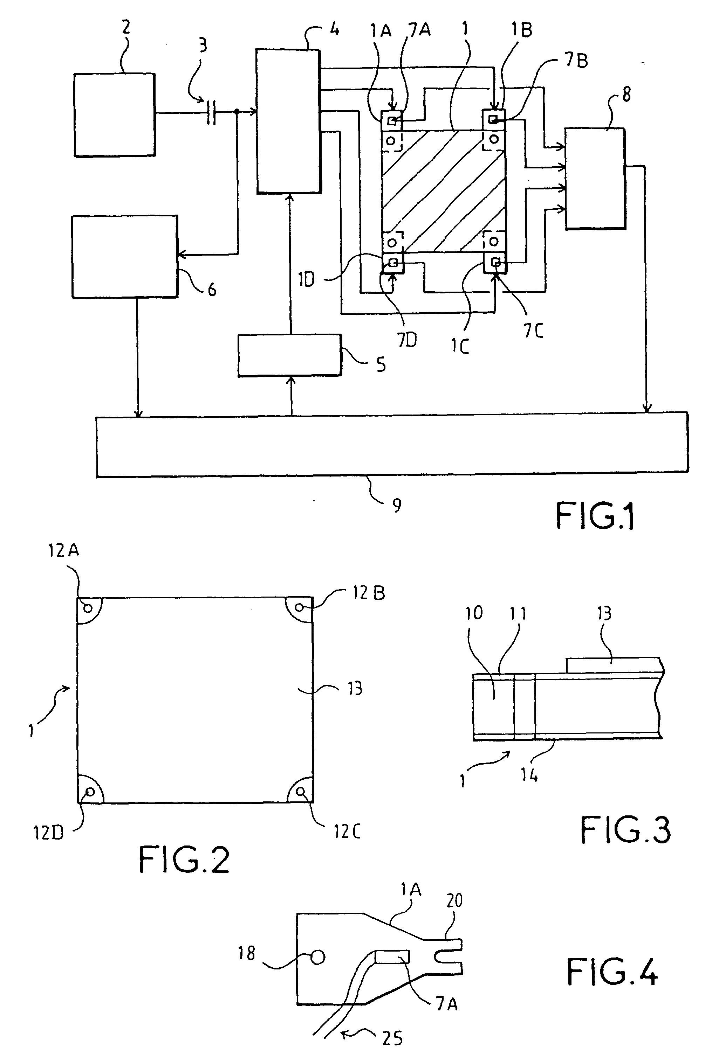

Comme représenté en figure 1, le dispositif de l'invention comporte une surface tactile capacitive 1 alimentée en haute fréquence par un générateur 2 via un condensateur d'injection 3 et un multiplexeur 4 qui est commandé par un séquenceur 5. Le point commun au condensateur 3 et au multiplexeur 4 est relié à un circuit de détection 6 réalisant l'adaptation d'impédance et une démodulation de signal HF (modulé par la variation locale d'impédance de la surface 1 lors de la désignation d'un point par l'utilisateur).

La surface capacitive 1 est avantageusement réalisée comme celle décrite dans le brevet français FR-A-2688 957 de la Demanderesse, et dont les éléments constituants principaux sont rappelés ci-dessous en référence aux figures 2 à 5. Les dispositifs de fixation souple 1A à 1D de la surface 1 sont associés chacun à une jauge de contrainte, respectivement 7A à 7D. Les jauges 7A à 7D sont reliées à un circuit 8 d'interface. Les éléments 5, 6 et 8 sont reliés à un calculateur 9.

Le générateur 2 a par exemple une fréquence d'environ 2 MHz, mais elle peut être comprise entre 500 kHz et 50 MHz environ. Le condensateur 3 a, par exemple, une valeur comprise entre 100 et 700 pF environ. L'impédance de la couche capacitive de la surface 1 est choisie de façon à assurer une bonne adaptation d'impédances avec le circuit d'injection de signal H.F. (à savoir les éléments 2 à 4 ). De façon avantageuse, la résistance de la couche capacitive de la plaque 1 , considérée selon l'une quelconque de ses diagonales, est comprise entre 500 et 20 000 Ohms. Dans tous les cas de réalisation, on cherche à optimiser la sensibilité de la surface tactile pour obtenir ladite adaptation d'impédances, en fonction de la capacité du condensateur 3, de la résistance de la couche capacitive de la plaque 1 et de la fréquence, c'est-à-dire à obtenir la meilleure sensibilité possible de cette plaque, la sensibilité étant définie ici comme la différence entre la tension détectée aux bornes de la couche conductrice (entre deux coins opposés ) sans appui tactile sur la surface et la tension avec appui sur cette surface.

La plaque 1 a un substrat 10 en verre (figures 2 et 3 ) et a par exemple une forme rectangulaire. Elle comporte sur toute sa surface supérieure (celle tournée vers l'utilisateur) un revêtement 11 en matériau électriquement conducteur, par exemple en l.T.O. (oxyde d'étain et d'indium), transparente en lumière visible. Des trous 12A à 12D sont percés aux quatre coins du substrat de verre 10. La couche 11 est revêtue d'une couche anti-reflets 13 sur toute sa surface sauf en ses quatre coins, autour des trous 12A à 12D , afin de permettre la connexion électrique entre les lames de support 1A à 1D et la couche conductrice 11. La face inférieure du substrat 10 est également recouverte d'une couche 14 anti-reflets.

Les lames de support 1A à 1D sont réalisées en matériau souple électriquement conducteur. Elles assurent la fixation de la plaque 1 sur un support 15 auquel est fixé un dispositif d'affichage 16 , la plaque 1 étant fixée au-dessus de ce dispositif 16, dont les images sont vues à travers la plaque 1. Le support 15 est avantageusement un circuit imprimé comportant les circuits électroniques auxquels est reliée la couche conductrice 11 via le condensateur 3. Dans le cas présent, le support 15 comporte une ouverture 17 à travers laquelle passe la partie supérieure du dispositif afficheur 16, mais il est bien entendu que, si ce dispositif afficheur 16 est peu épais, on peut ne pas pratiquer l'ouverture 17 et fixer le dispositif afficheur 16 sur la face supérieure du support 15, le dispositif de fixation de la plaque 1 étant alors modifié en conséquence pour la surélever suffisamment au-dessus de l'afficheur 16.

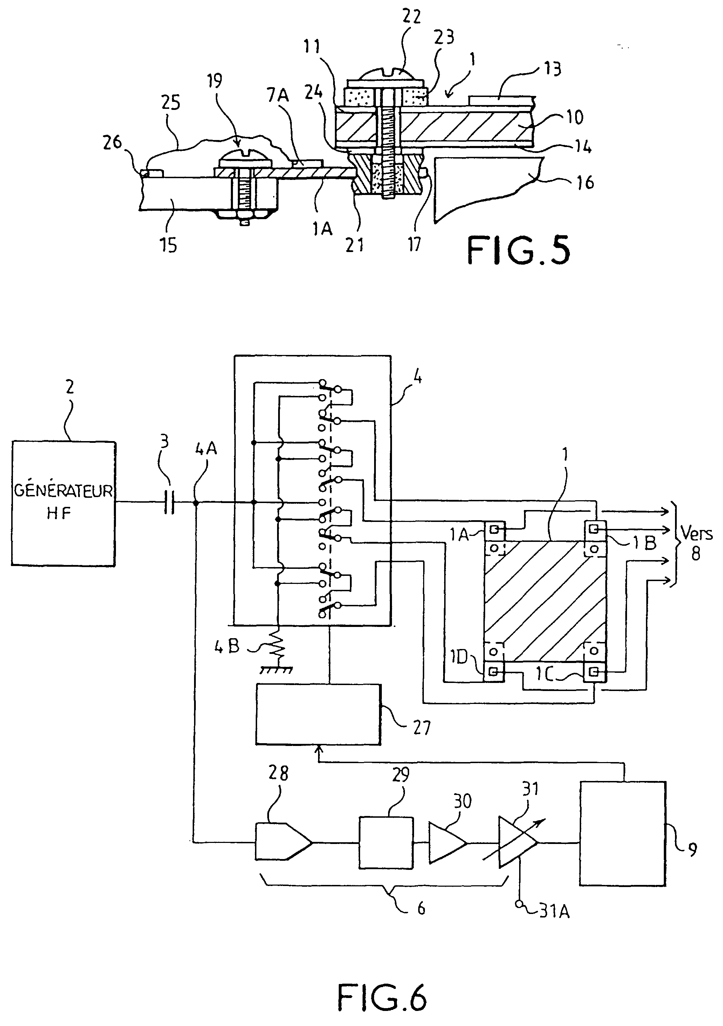

On a représenté en figure 4 un exemple de réalisation d'un dispositif de fixation souple de la plaque 1 sur le support 15. Ce dispositif 1A se présente par exemple sous forme d'une lamelle en métal souple, dont une extrémité est percée d'un trou 18 permettant de la fixer sur le support 15 à l'aide d'un ensemble 19 à vis et écrou. L'autre extrémité de la lamelle 1A a une forme de fourche en "U" 20, cette fourche s'engageant dans la gorge périphérique d'un écrou 21 électriquement conducteur en forme de diabolo, cet écrou 21 étant vissé sur une vis 22 passant dans le trou 12A. Une rondelle souple, électriquement conductrice, est interposée entre la tête de la vis 22 et la couche conductrice 11. Une ou plusieurs rondelles métalliques 24 sont interposées entre l'écrou 21 et la couche 14, et servent au réglage en hauteur de la plaque 1 par rapport au support 15. La jauge 7A est fixée, par exemple par collage, sur une des faces de la lamelle 1A, à peu près au milieu de sa longueur, et cette jauge est reliée par des fils conducteurs souples 25 au circuit 26 d'alimentation de la jauge et de traitement associé. Ce circuit étant bien connu en soi ne sera pas décrit ici.

On a représenté en figure 6 le bloc-diagramme du dispositif de traitement des signaux dus à la surface tactile 1. Le circuit séquenceur ou multiplexeur 4 est commandé par un dispositif de commande 27 de façon à relier la borne d'entrée 4A du multiplexeur 4 successivement à chacune des lames de support et de contact électrique 1A à 1D, correspondant aux quatre coins de la surface 1, les trois autres coins étant non connectés ou reliés à la masse, à chaque fois via une résistance 4B.

La borne 4A est, par ailleurs, reliée à une chaîne de traitement comportant un filtre passe-bande 28, un démodulateur d'amplitude 29, un amplificateur 30 à translation de niveau (à rétablissement de la composante continue) et un amplificateur 31 à gain variable (dont la borne 31A de commande de gain est reliée au processeur 9). La sortie de l'amplificateur 31 est reliée au processeur. L'ensemble des éléments 28 à 31 constitue le circuit 6, cité ci-dessus.

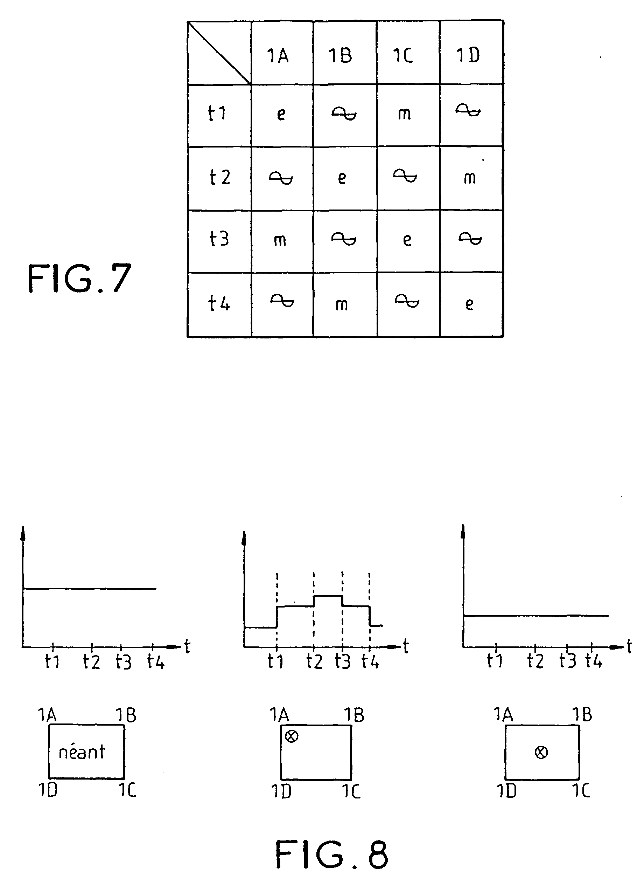

On a représenté sur le tableau de la figure 7 un exemple de cycle de commande du multiplexeur 4. Ce cycle comprend quatre phases repérées t1 à t4. Les différentes commandes sont repérées par les références des lames (1A à 1D) correspondant aux quatre coins de la surface 1. Les deux actions possibles sont repérées m (mise à la masse du coin considéré) ou e (application d'une tension haute fréquence e sur le coin considéré) ou ∞ (coin non connecté). Comme précisé ci-dessus, à chacune des phases t1 à t4, un seul des coins reçoit la tension e, le coin opposé est mis à la masse via la résistance 4B et les deux autres coins sont non connectés, et au cours d'un cycle complet, les quatre coins reçoivent tour à tour la tension e.

La tension haute fréquence e recueillie au point 4A est fonction du coin de la surface 1 alimenté et de l'endroit de cette surface sur lequel appuie l'utilisateur. Le fait d'alimenter successivement les quatre coins de la surface 1 permet de lever l'indétermination due aux symétries présentées par cette surface (étant bien entendu qu'elle est homogène).

On a représenté en figure 8 trois cas différents pour une surface carrée, dans l'ordre : pas d'attouchement de la surface, attouchement (avec appui sur la surface) près du coin 1A sur la diagonale A-C, et attouchement (toujours avec appui) près de son centre. Cet attouchement introduit une capacité entre le point d'attouchement et la masse (via l'utilisateur), cette capacité formant, avec la résistance résultante entre le point et le coin mis à la masse, un pont diviseur vis-à-vis de la tension à la borne 4A. On considère que, pendant au moins un cycle complet du multiplexeur 4, le doigt de l'utilisateur ne bouge pas, c'est-à-dire que les cycles du multiplexeur sont très courts vis-à-vis du temps pendant lequel l'utilisateur appuie sur la surface 1. Dans le premier cas, les quatre tensions recueillies sont identiques du fait des symétries géométriques, et donc électriques, de la surface. Dans le second cas, la capacité d'attouchement due à l'utilisateur introduit entre le point d'attouchement et la masse une impédance qui diminue fortement la valeur de la tension recueillie sur la borne 4A, du fait que le point d'attouchement est proche du coin 1A recevant la tension haute fréquence et qu'en conséquence cette capacité vient en parallèle sur la résistance résultante (représentant la plus grande partie de la résistance de la couche 11 vue entre le coin 1A et le coin relié à la masse) entre le point d'attouchement et la masse. Pour l'alimentation du coin opposé 1C, la situation est inversée : la capacité d'attouchement vient en parallèle sur une résistance représentant une faible partie de la résistance de la couche 11 vue entre le coin 1C et la masse. La tension à la borne 4A diminue alors très peu. Lors de l'alimentation des deux autres coins 1B et 1D, la résistance de la surface 11 vue de l'un de ces coins est pratiquement la même que celle vue de l'autre coin, le point d'attouchement étant sur la diagonale A-C. De plus; du fait que le point d'attouchement est proche du coin 1A, la capacité apportée par l'utilisateur perturbe à peine l'impédance vue des coins 1B et 1D.

La résistance 4B sert non seulement de "résistance de garde" (pour recueillir en 4A une tension minimale mesurable lorsque le point d'attouchement est très proche d'un coin et que ce coin est alimenté en haute fréquence), mais également de "résistance de linéarisation" permettant d'obtenir une sensibilité de valeur correcte et à peu près linéaire en fonction de la résistance résultante au point d'attouchement.

Ainsi, pour pouvoir déterminer automatiquement l'emplacement du point d'attouchement en utilisation normale, on procède d'abord à une étape d'étalonnage en relevant, pour différents points d'attouchement répartis sur toute la partie utile de la surface 1, les tensions relatives aux quatre coins 1A à 1D et en les mémorisant dans une table de conversion (incluse dans le calculateur 9). Etant donné que l'on explore successivement les quatre coins, il ne peut y avoir d'ambiguïtés dues à des symétries : à chaque point d'attouchement de la surface 1 correspond un seul et unique ensemble de quatre tensions correspondant aux quatre coins 1A à 1D. En utilisation normale, il suffit de comparer, pour un point d'attouchement donné, les quatre tensions relevées et de les comparer à chacun des ensembles mémorisés pour déterminer l'emplacement du point d'attouchement.

Pour simplifier la comparaison, on peut avantageusement superposer à la surface 1 une matrice orthogonale virtuelle la divisant en petits carrés ou rectangles formant un damier, dont chacun représenterait une "touche". On relève alors les tensions relatives aux quatre coins 1A à 1D pour un attouchement au centre de chacune de ces touches. En fonction des tensions recueillies pour des touches voisines, on calcule une tension moyenne correspondant à la frontière entre deux touches voisines selon chacun des axes de coordonnées de la matrice. Les tensions moyennes ainsi déterminées fixent, lors de l'étape de comparaison en utilisation normale, les seuils pour lesquels il y a passage d'une touche à une autre. Les différentes tensions relevées et comprises entre deux seuils successifs, dans les deux directions des axes de la matrice, sont alors assimilées à la tension relevée pour un attouchement au centre de la touche, et produisent toutes la même information correspondant à cette touche.

L'amplificateur 31 à gain variable permet d'exploiter le dispositif de l'invention dans des conditions d'utilisation variées. En effet, dans certains cas, l'utilisateur peut être amené à porter des gants qu'il ne peut enlever pour désigner une zone de la surface 1, alors que dans d'autres cas, la même surface peut être exploitée à mains nues. Bien entendu, la capacité rapportée par un utilisateur portant des gants est bien plus faible que lorsqu'il n'en porte pas, et par conséquent les tensions recueillies dans ces deux cas sont différentes, et d'autant plus que les gants sont épais, cette différence pouvant varier avec la force d'appui sur la surface 1. Pour y remédier, l'invention prévoit de relever les tensions aux quatre coins 1A à 1D pendant au moins un cycle, sans effectuer de comparaison avec ladite table de conversion. Le calculateur 9 calcule par exemple la valeur moyenne des quatre tensions ainsi recueillies, et en fonction de cette valeur moyenne, commande le gain de l'amplificateur 31 de façon à obtenir, pour un cycle de mesure suivant, une valeur moyenne standardisée de ces quatre tensions, valeur standardisée que l'on peut obtenir dans tous les cas d'utilisation envisagés.

Selon une variante, au lieu de faire varier, dans de larges proportions, le gain de l'amplificateur 31, on fait varier ce gain dans une plage de valeurs réduite, et on prévoit plusieurs tables de conversion dont une seule est adressée en fonction de la moyenne des tensions recueillies aux quatre coins de la surface 1.

Selon une autre caractéristique avantageuse de l'invention, afin de prendre en compte l'usure de la surface 1, on mesure, lors de la première utilisation, les tensions en 4A sans appui sur la surface transparente, pour au moins un cycle de mesure des coins 1A à 1D, et on mémorise ces tensions (qui, en principe, doivent être toutes égales). On peut alors surveiller l'évolution au cours du temps de l'impédance de la surface capacitive en comparant les valeurs ainsi mémorisées avec les valeurs courantes mesurées également sans appui de la surface. Ces comparaisons peuvent être effectuées automatiquement au début de chaque période d'utilisation. Le résultat de la comparaison peut, dans le cas d'une forte différence, servir à déclarer une panne et/ou à avertir de la nécessité de procéder à une opération de changement de la surface. Dans le cas d'une faible dérive, le calculateur 9 peut modifier en conséquence le gain de l'amplificateur 31.

Grâce au fait que les quatre coins de la surface capacitive sont alimentés séquentiellement par un dispositif unique d'injection de courant et de mesure commuté, le dispositif de l'invention n'a pas besoin d'interfaces appairées, n'est pas perturbé par des dérives de composants, et peut être utilisé dans des conditions très diverses : attouchement non ponctuel, avec des gants, dans un environnement hostile (vibrations, vapeur, buée, ...). La qualité du revêtement conducteur n'altère pratiquement pas la précision de détermination, et il peut donc être très fin (épaisseur de quelques couches atomiques) et présenter ainsi de bonnes qualités optiques (transparence, traitement anti-reflets...).

## Revendications

1. Dispositif de désignation tactile à surface capacitive transparente, comportant une plaque de verre (10) sensiblement rectangulaire à dépôt métallique transparent continu (11), cette plaque étant supportée en ses coins par des lames flexibles (1A à 1D) sur lesquelles sont fixées des jauges de contrainte (7A à 7D), ces lames pouvant assurer la connexion électrique entre le dépôt métallique de la plaque de verre et des circuits électroniques, cette connexion comportant un condensateur série (3), les circuits électroniques comportant des circuits d'alimentation haute fréquence (2) et un calculateur (9), **caractérisé en ce qu'**il comporte un circuit de détection (6) dont un pôle (4A) est alternativement relié à chacun des coins (1A à 1D) du dépôt métallique (11), le coin opposé étant relié à l'autre pôle du circuit de détection, les deux autres coins étant non connectés.

2. Dispositif selon la revendication 1, **caractérisé en ce que** les circuits d'alimentation haute fréquence (2) ont une fréquence comprise entre 500 kHz et 50 MHz environ.

3. Dispositif selon la revendication 1 ou 2, **caractérisé en ce que** le condensateur série (3) a une valeur comprise entre 100 et 700 pF environ.

4. Dispositif selon l'une des revendications précédentes, **caractérisé en ce que** ledit coin opposé est relié à l'autre pôle du circuit à travers une résistance (4B).

5. Dispositif selon l'une des revendications précédentes, **caractérisé en ce que** les circuits électroniques comportent un amplificateur à gain variable (31).

6. Dispositif selon l'une des revendications précédentes, **caractérisé en ce que** le calculateur (9) comporte au moins une table de conversion dans laquelle sont mémorisées des valeurs de tension relevées pour différents points d'attouchement de la surface capacitive (1).

7. Dispositif selon la revendication 6, **caractérisé en ce que** les points d'attouchement correspondent aux centres de touches d'un réseau cartésien de touches virtuelles de la surface capacitive.

## Claims

1. Touch-sensitive designating device with transparent capacitive surface, comprising a substantially rectangular glass sheet (10) having a continuous transparent metallic deposition (11), this sheet being supported at its corners by flexible strips (1A to 1D) on which are fixed strain gauges (7A to 7D), these strips being able to provide for the electrical connection between the metallic deposition of the glass sheet and electronic circuits, this connection comprising a series capacitor (3), the electronic circuits comprising high-frequency supply circuits (2) and a computer (9), **characterized in that** it comprises a detection circuit (6), one pole (4A) of which is alternately linked to each of the corners (1A to 1D) of the metallic deposition (11), the opposite. corner being linked to the other pole of the detection circuit, the other two corners being unconnected.

2. Device according to Claim 1, **characterized in that** the high-frequency supply circuits (2) have a frequency of between 500 kHz and 50 MHz approximately.

3. Device according to Claim 1 or 2, **characterized in that** a series capacitor (3) has a value of between 100 and 700 pF approximately.

4. Device according to one of the preceding claims, **characterized in that** the said opposite corner is linked to the other pole of the circuit across a resistor (4B).

5. Device according to one of the preceding claims, **characterized in that** the electronic circuits comprise a variable-gain amplifier (31).

6. Device according to one of the preceding claims, **characterized in that** the computer (9) comprises at least one conversion table in which are stored voltage values sensed for various points of touching of the capacitive surface (1).

7. Device according to Claim 6, **characterized in that** the points of touching correspond to the centres of touch pads of a cartesian array of virtual touch pads of the capacitive surface.

## Patentansprüche

1. Berührungsempfindliche Vorrichtung mit einer transparenten kapazitiven Fläche, die eine im wesentlichen rechtwinklige Glasplatte (10) mit einer durchgehenden transparenten Metallschicht (11) enthält, wobei diese Platte an ihren Ecken (1A bis 1D) durch flexible Plättchen gehalten wird, auf denen Kraftmeßsonden (7A bis 7D) befestigt sind und die die elektrische Verbindung zwischen der Metallbeschichtung der Glasplatte und elektronischen Schaltungen gewährleisten können, wobei diese elektrische Verbindung einen Kondensator (3) in Reihenschaltung enthält und die elektronischen Schaltungen eine Schaltung (2) zur Lieferung einer Hochfrequenzspannung und einen Rechner (9) besitzt, **dadurch gekennzeichnet, daß** sie eine Erfassungsschaltung (6) enthält, von der ein Pol (4A) abwechselnd mit jeder der Ecken (1A bis 1D) der Metallschicht (11) verbunden wird, während zugleich ihr anderer Pol mit der gegenüberliegende Ecke verbunden wird und die beiden restlichen Ecken nicht angeschlossen werden.

2. Vorrichtung nach Anspruch 1, **dadurch gekennzeichnet, daß** die Schaltung (2) zur Lieferung der Hochfrequenzspannung diese mit einer Frequenz zwischen etwa 500 kHz und 50 MHz liefert.

3. Vorrichtung nach Anspruch 1 oder 2, **dadurch gekennzeichnet, daß** der Serienkondensator (3) einen Kapazitätswert etwa zwischen 100 pF und 700 pF besitzt.

4. Vorrichtung nach einem der vorstehenden Ansprüche, **dadurch gekennzeichnet, daß** die gegenüberliegende Ecke an den zweiten Pol der Erfassungsschaltung über einen Widerstand (4B) angeschlossen ist.

5. Vorrichtung nach einem der vorstehenden Ansprüche, **dadurch gekennzeichnet, daß** die elektronischen Schaltungen einen Verstärker (31) mit variablem Verstärkungsgrad besitzen.

6. Vorrichtung nach einem der vorstehenden Ansprüche, **dadurch gekennzeichnet, daß** der Rechner (9) mindestens eine Konversionstabelle enthält, in der Spannungswerte gespeichert sind, die für verschiedene Punkte auf der kapazitiven Fläche (1) gemessen wurden.

7. Vorrichtung nach Anspruch 6, **dadurch gekennzeichnet, daß** die Tastpunkte den Mittelpunkten von Tasten eines kartesischen Netzes von virtuellen Tasten auf der kapazitiven Fläche entsprechen.
